# EUROPEAN PATENT APPLICATION

(11) **EP 4 797 486 A1**
(43) Date of publication of application: **26.08.2026**
(21) Application number: 24884120.7
(22) Date of filing: 13.08.2024
(51) Int. Cl.: H02J 7/00, H02H 7/18, H02J 3/08

(54) **ENERGY STORAGE SYSTEM AND POWER SOURCE APPARATUS**

(30) Priority: 03.11.2023 WO PCT/CN2023/129688; 20.11.2023 CN 202323118929 U
(71) Applicant: Contemporary Amperex Technology Co., Limited, Ningde, Fujian 352100 (CN)
(72) Inventor: HAO, Yucang, Ningde, Fujian 352100 (CN); JIANG, Qijiang, Ningde, Fujian 352100 (CN); CHEN, Xiaobo, Ningde, Fujian 352100 (CN); ZHOU, Yuan, Ningde, Fujian 352100 (CN)
(74) Representative: Kraus & Lederer PartGmbB
(86) International application number: PCT/CN2024/111751
(87) International publication number: WO 2025/092113

(57) **Abstract**

An energy storage system and a power source apparatus, which belong to the technical field of power sources. The energy storage system comprises: a general positive line, a general negative line and a battery module connected between the general positive line and the general negative line, and the battery module comprises M battery assemblies (11) connected in series. The energy storage system further comprises: N supporting members (12), wherein the M battery assemblies (11) are supported by means of the N supporting members (12), and the M battery assemblies (11) are insulated from the N supporting members (12). The energy storage system further comprises: a conductive path, wherein K supporting members (12) among the N supporting members (12) are connected to the conductive path by means of K branches, respectively, M, N and K are all positive integers, and M≥N≥K>1. A protective assembly (13) is arranged on the conductive path and/or the branch in series. Thus, a short-circuit current is expected to be reduced when double-point insulation of a cross-electrical-box (a supporting member) fails, and the possibility of initiating high-voltage ignition and battery combustion and explosion is reduced.

## Description

The present application claims priority to Chinese Patent Application 202323118929.8, filed with the Chinese Patent Office on November 20, 2023 and entitled "ENERGY STORAGE CIRCUIT AND POWER SOURCE APPARATUS", and Chinese Patent Application PCT/CN2023/129688, filed on November 03, 2023 and entitled "ENERGY STORAGE CIRCUIT AND POWER SOURCE APPARATUS", which are incorporated herein by reference in entirety.

### TECHNICAL FIELD

The present application belongs to the technical field of power sources, and particularly relates to an energy storage system and a power source apparatus.

### BACKGROUND

Related energy storage system includes a plurality of battery packs that are connected in series and/or parallel, with the short-circuit protection method being to provide a fuse at a positive electrode or negative electrode of the energy storage system, or to provide a fuse inside each battery pack. These two methods can only reduce the probability of severe safety failures such as battery combustions or explosion when a short circuit occurs at the positive electrode or negative electrode of the energy storage system, but are easy to cause severer safety problems such as high-voltage ignition and battery combustion and explosion due to high voltage difference and extremely large short-circuit current when double-point insulation of a cross-electrical-box (a supporting member) fails, namely, when the insulation of two separate electrical boxes fails.

Therefore, the related energy storage system cannot reduce the safety risks when double-point insulation of the cross-electrical-boxes fails.

### SUMMARY

In view of the above problems, the present application provides an energy storage system and a power source apparatus, and aims to solve the problem that the related energy storage system cannot reduce the safety risks when double-point insulation of cross-electrical-boxes fails.

### Technical solutions

The embodiments of the present application adopt the technical solution as follows:
in a first aspect, the embodiment of the present application provides an energy storage system, which includes a general positive line, a general negative line, and a battery module connected between the general positive line and the general negative line; the energy storage system is configured to output electric energy from the battery module by means of the general positive line and the general negative line, and/or, the energy storage system is configured to input electric energy to the battery module by means of the general positive line and the general negative line;
the battery module includes M battery modules connected in series;
the energy storage system further includes N supporting members, in which, the M battery modules are supported by means of the N supporting members, and the M battery assemblies are insulated from the N supporting members;
the energy storage system further includes a conductive path, in which, K supporting members among the N supporting members are connected to the conductive path by means of K branches, respectively, M, N, and K are all positive integers, and M≥N≥K>1; and
a protection assembly is arranged on the conductive path and/or the branches in series.

According to the technical solution of the embodiment of the present application, the battery assemblies and the supporting members are arranged in an insulated manner; the K supporting members among the N supporting members are connected to the conductive path by means of the K branches, respectively, and the protection assembly is arranged on the conductive path and/or the branches, such that if double-point insulation of cross-electrical-boxes (the supporting members) fails, namely, if insulation of the supporting members fails, respectively, the protection assembly connected in series between two supporting members with insulation failure influences current among the N supporting members to achieve a protection effect, reducing short-circuit current, and reducing the possibility of initiating high-voltage ignition and battery combustion and explosion.

In some embodiments, the K branches are connected to the conductive path to form K nodes;
the protection assembly includes at least one first sub-protection assembly, and the number of the at least one first sub-protection assembly is ≤ K-1; and one or zero of the at least one first sub-protection assembly is connected in series between any two adjacent nodes in the K nodes.

By means of above solution, the number of the first sub-protection assemblies configured can be reduced, thus saving the cost.

In some embodiments, the number of the at least one first sub-protection assembly is K-1, and one of the at least one first sub-protection assembly is connected in series between any two adjacent nodes in the K nodes.

By means of above solution, the first sub-protection assembly is arranged between every two adjacent supporting members, such that if insulation of any two supporting members fails, there will be one sub-protection assembly to influence the short-circuit current, thus further reducing the possibility of initiating high-voltage ignition and battery combustion and explosion.

In some embodiments, the conductive path includes K-1 sub-paths formed by the K nodes, a target sub-path is arranged every m sub-paths, the target sub-paths are connected in series with the first sub-protection assemblies, and m is a natural number.

By means of above solution, the first sub-protection assemblies can be arranged every 0 or more sub-paths, thereby improving the configuration flexibility of the first protection assemblies.

In some embodiments, m is 0, the number of the at least one first sub-protection assembly is K-1, and the K-1 first sub-protection assemblies are connected in series onto the K-1 sub-paths, respectively.

By means of above solution, the first sub-protection assembly is arranged between every two adjacent supporting members, such that if insulation of any two supporting members fails, there will be one sub-protection assembly to influence the short-circuit current, thus further reducing the possibility of initiating high-voltage ignition and battery combustion and explosion.

In some embodiments, each first sub-protection assembly has the same resistance.

By means of above solution, the voltage differences between the adjacent supporting members are equal, therefore, if insulation of the two supporting members fails, the stability of the current limiting effect of one or more first sub-protection assemblies is improved, thereby further reducing the possibility of initiating high-voltage ignition and battery combustion and explosion.

In some embodiments, the energy storage system further includes:
a plurality of first capacitive assemblies connected in parallel with the plurality of first sub-protection assemblies one by one.

By means of above solution, in cases of lightning strikes, surges, and the like, each first capacitive assembly performs spike voltage suppression on voltage of each first sub-protection assembly, thereby reducing the probability of breakdown of the first sub-protection assemblies, improving the reliability of the energy storage system, and moreover, filtering out the spike voltage between the general positive line and general negative line, enhancing the stability of the energy storage system.

In some embodiments, each first capacitive assembly has the same capacitance.

By means of above solution, each first capacitive assembly has the same capacitance, so that the peak voltage suppression capabilities at both ends of each first sub-protection assembly are the same, and the stability and reliability of the energy storage system are further improved.

In some embodiments, a positive electrode of a first battery assembly is connected to the general positive line, and a first node formed by connecting a first branch in the K branches to the conductive path is connected to the general positive line; and a negative electrode of an Mth battery assembly is connected to the general negative line, and a Kth node formed by connecting a Kth branch in the K branches to the conductive path is connected to the general negative line.

By means of above solution, the protection assemblies form a voltage-sharing chain, and the voltage-sharing chain provides the possibility of serving as a voltage dividing resistor, such that it is not needed to arrange the voltage dividing resistor, the hardware design is simplified, and the cost is saved.

In some embodiments, the energy storage system further includes two second sub-protection assemblies; and
one second sub-protection assembly is connected in series between the first node and the general positive line, as well as between the Kth node and the general negative line, respectively.

One second sub-protection assembly is connected in series between the first node and the general positive line, as well as between the Kth node and the general negative line, respectively, therefore, if the insulation of the first supporting member and/or an Nth supporting member fails, there is one sub-protection assembly to influence the short-circuit current, thereby further reducing the possibility of initiating high-voltage ignition and battery combustion and explosion.

In some embodiments, a disconnecting switch module, a relay module, and a filter module are sequentially connected in series on the general positive line and the general negative line; the filter module is configured to filter a first direct current outputted by the battery module;
the second sub-protection assemblies are commonly connected to the disconnecting switch module; or
the second sub-protection assemblies are commonly connected to the disconnecting switch module and the relay module; or
the second sub-protection assemblies are commonly connected to the filter module.

The disconnecting switch module, the relay module, and the filter module are sequentially connected in series onto the general positive line and the general negative line, thereby improving the stability of the first direct current, as well as improving the output flexibility of the first direct current; and the second sub-protection assemblies are connected to different positions on the general positive line and the general negative line, thereby improving the protection flexibility of the energy storage system.

In some embodiments, if the resistance of each first sub-protection assembly is a first resistance R, the resistance of each second sub-protection assembly is half or twice of the first resistance R.

By means of above solution, the voltage differences between the adjacent supporting members are equal, therefore, if insulation of the two supporting members fails, the stability of the current limiting effect of one or more first sub-protection assemblies is improved, thereby further reducing the possibility of initiating high-voltage ignition and battery combustion and explosion; meanwhile, it can be set as that the voltage difference between the first supporting member and the general positive line and the voltage difference between the nth supporting member and the general negative line are half of a voltage drop of each first sub-protection assembly, thus the stability of the current limiting effect of the voltage-sharing chain is further improved, and the possibility of initiating high-voltage ignition and battery combustion and explosion is further reduced; or it can be set as that the voltage difference between the first supporting member and the general positive line and the voltage difference between the nth supporting member and the general negative line are multiple times of the voltage drop of each first sub-protection assembly, thus the voltage can be distinguished, and insulation detection is facilitated.

In some embodiments, the energy storage system further includes:
a plurality of second capacitive assemblies which are connected in parallel with the plurality of second sub-protection assemblies one by one.

By means of above solution, in cases of lightning strikes, surges, and the like, each second capacitive assembly performs spike voltage suppression on voltage of each second sub-protection assembly, thereby reducing the probability of breakdown of the second sub-protection assemblies, improving the reliability of the energy storage system, and moreover, filtering out the spike voltage between the general positive line and general negative line, enhancing the stability of the energy storage system.

In some embodiments, if the capacitance of each first capacitive assembly connected in parallel with each first sub-protection assembly is a first capacitance C, the capacitance of each second capacitive assembly is 1/2 of the first capacitance C.

By means of above solution, each first capacitive assembly has the same capacitance, so that the peak voltage suppression capabilities at both ends of each first current limiting assembly are the same, and the stability and reliability of the energy storage system are further improved.

In some embodiments, the protection assembly includes at least one third sub-protection assembly, the number of the third sub-protection assemblies is ≤ K, and the at least one third sub-protection assembly is connected in series onto at least one of the K branches.

By means of above solution, the third sub-protection assemblies are arranged on the K branches, thus if double-point insulation of the cross-electrical-box (supporting member) fails, short-circuit current will be influenced, thereby reducing the possibility of initiating high-voltage ignition and battery combustion and explosion, while making wiring more flexible; and meanwhile, the number of the third sub-protection assemblies configured can be decreased, thus saving the cost.

In some embodiments, the protection assembly includes K third sub-protection assemblies, and the K third sub-protection assemblies are connected in series onto the K branches, respectively.

By means of above solution, the third sub-protection assemblies are arranged between the adjacent supporting members, and if the insulation of any two supporting members fails, at least two third protection assemblies can be used for protecting against the short-circuit current, thereby further reducing the possibility of initiating high-voltage ignition and battery combustion and explosion.

In some embodiments, each third sub-protection assembly has the same resistance.

By means of above solution, the voltage differences between the adjacent supporting members are equal, thus if the insulation of the two supporting members fails, the stability of the current limiting effect can be improved, thereby further reducing the possibility of initiating high-voltage ignition and battery combustion and explosion.

In some embodiments, the energy storage system further includes:
a plurality of third capacitive assemblies which are connected in parallel with the at least one third sub-protection assembly one by one.

By means of above solution, in cases of lightning strikes, surges, and the like, each third capacitive assembly performs spike voltage suppression on voltage of each third sub-protection assembly, thereby reducing the probability of breakdown of the third sub-protection assemblies, improving the reliability of the energy storage system, and moreover, filtering out the spike voltage between the general positive line and general negative line, enhancing the stability of the energy storage system.

In some embodiments, one or more of the N supporting members are connected to an electrical platform.

By means of above solution, the voltage-sharing chain including the protection assemblies is used as the voltage dividing resistor at the same time, such that it is not needed to arrange the voltage dividing resistor, the hardware design is simplified, and the cost is saved.

In some embodiments, if N is an even number, the N/2th supporting member is connected to the electrical platform; and
if N is an odd number, the (N +1)/2th supporting member is connected to the electrical platform.

By means of above solution, the middlemost supporting member is connected to the electrical platform, thus if the electrical platform is grounded, the maximum value of an absolute value of the voltage of the general positive line and the absolute value of the voltage of the general negative line is minimum, thereby further improving the safety and the reliability of the energy storage system.

In some embodiments, the energy storage system further includes a first supporting device, and the first supporting device is configured to support the N supporting members and is connected to the electrical platform.

By means of above solution, the first supporting device is connected to the electrical platform, thus the wiring is facilitated, it is not needed to set different protection modes for various operating conditions; and the first supporting device is in a non-suspended state, such that the protection mode is simple.

In some embodiments, one of the general positive line, the general negative line, and the conductive path is connected to the electrical platform.

By means of above solution, the wiring flexibility is improved, and various protection modes can be provided for various operating conditions.

In some embodiments, the energy storage system further includes two second voltage dividing assemblies;
the two second voltage dividing assemblies are connected in series between the general positive line and the general negative line; and
an intermediate node of the two second voltage dividing assemblies is connected to the electrical platform.

By means of above solution, the two second voltage dividing assemblies are arranged, and a common contact of the two second voltage dividing assemblies is clamped at a potential of the electrical platform, such that the safety of the energy storage system is improved, the maximum value of the absolute value of the voltage of the general positive line and the maximum value of the absolute value of the voltage of the general negative line are minimum, thereby further improving the safety and reliability of the energy storage system.

In some embodiments, the energy storage system further includes:
a conversion circuit which is connected to the general positive line and the general negative line and is configured to convert a first direct current outputted by the battery module so as to output an alternating current.

By means of above solution, the first direct current is subjected to direct-current and alternating-current conversion to realize alternating-current output of the energy storage module.

In some embodiments, the protection assembly is a current limiting assembly which is configured to limit the current generated in the conductive path; or
the protection assembly is an overcurrent protection assembly which is configured to carry out overcurrent protection on the conductive path.

By means of above solution, the protection assembly can be the current limiting assembly or the overcurrent protection assembly, and thus the configuration flexibility of the protection assembly is improved.

In a second aspect, the embodiment of the present application further provides a power source apparatus, which includes a load and the abovementioned energy storage system.

The above description is only an overview of the technical solution of the present application, and in order to be able to understand more clearly the technical means of the present application, it can be implemented in accordance with the contents of the description, and in order to make the above and other purposes, characteristics and advantages of the present application more obvious and easy to understand, the specific embodiments of the present application are listed below.

### Beneficial effects

The beneficial effect in the first aspect provided by the embodiments of the present application is that: in the technical solution of the embodiments of the present application, the battery assemblies and the supporting members are arranged in an insulated manner; the K supporting members among the N supporting members are connected to the conductive path by means of K branches, respectively, and the protection assembly is arranged on the conductive path and/or the branches, such that if double-point insulation of cross-electrical-boxes (the supporting members) fails, namely, if insulation of the supporting members fails, respectively, the protection assembly connected in series between two supporting members with insulation failure influences current among the N supporting members to achieve a protection effect, reducing short-circuit current, and reducing the possibility of initiating high-voltage ignition and battery combustion and explosion.

### BRIEF DESCRIPTION OF THE DRAWINGS

In order to explain the technical scheme in the embodiments of this application more clearly, the accompanying drawings needed in the description of the embodiments or demonstration technical descriptions will be briefly introduced below. Obviously, the accompanying drawings in the following description are only some embodiments of the application. For a person of ordinary skill in the art, other drawings can be obtained according to these accompanying drawings without creative work.

By reading the detailed description of the following preferred embodiments, various other advantages and benefits will become clear to those with ordinary skill in the art. The drawings are used for the purpose of illustrating the preferred embodiments only and are not to be considered a limitation to the present application. Moreover, in all of the drawings, the same components are indicated by the same reference numerals. In the accompanying drawings:
FIG. 1 is one schematic structural diagram of an energy storage system provided in an embodiment of the present application;
FIG. 2 is another schematic structural diagram of an energy storage system provided in an embodiment of the present application;
FIG. 3 is another schematic structural diagram of an energy storage system provided in an embodiment of the present application;
FIG. 4 is another schematic structural diagram of an energy storage system provided in an embodiment of the present application;
FIG. 5 is one schematic diagram of some circuit examples of an energy storage system provided in an embodiment of the present application;
FIG. 6 is another schematic structural diagram of an energy storage system provided in an embodiment of the present application;
FIG. 7 is another schematic structural diagram of an energy storage system provided in an embodiment of the present application;
FIG. 8 is another schematic structural diagram of an energy storage system provided in an embodiment of the present application;
FIG. 9 is another schematic structural diagram of an energy storage system provided in an embodiment of the present application;
FIG. 10 is another schematic structural diagram of an energy storage system provided in an embodiment of the present application;
FIG. 11 is another schematic structural diagram of an energy storage system provided in an embodiment of the present application;
FIG. 12 is another schematic structural diagram of an energy storage system provided in an embodiment of the present application;
FIG. 13 is another schematic structural diagram of an energy storage system provided in an embodiment of the present application;
FIG. 14 is another schematic diagram of some circuit examples of an energy storage system provided in an embodiment of the present application;
FIG. 15 is another schematic structural diagram of an energy storage system provided in an embodiment of the present application;
FIG. 16 is another schematic diagram of some circuit examples of an energy storage system provided in an embodiment of the present application;
FIG. 17 is another schematic structural diagram of an energy storage system provided in an embodiment of the present application;
FIG. 18 is another schematic diagram of some circuit examples of an energy storage system provided in an embodiment of the present application;
FIG. 19 is another schematic structural diagram of an energy storage system provided in an embodiment of the present application;
FIG. 20 is another schematic diagram of some circuit examples of an energy storage system provided in an embodiment of the present application.

### DETAILED DESCRIPTION

The embodiments of the technical solutions of the present application will be described in detail below with reference to the accompanying drawings. The following embodiments are only used to illustrate the technical solutions of the present application more clearly, and thus are only interpreted as examples, rather than used to limit the scope of protection of the present application.

Unless otherwise defined, all technical and scientific terms used herein have the same meanings as those commonly understood by those skilled in the art of the present application. The terms used herein are intended only for the purpose of describing specific embodiments and are not intended to limit the present application. The terms "including" and "having" and any variations thereof in the specification and claims of the present application and in the description of the above accompanying drawings are intended to cover non-exclusive inclusion.

In the description of the embodiments of the present application, the technical terms "first", "second", etc., are only used for distinguishing different objects, and cannot be understood as indicating or implying relative importance or implying the number, specific order or primary and secondary relationship of the technical features indicated. In the description of the embodiments of the present application, the meaning of "a plurality of" is two or more, unless otherwise explicitly and specifically defined.

The "embodiment" mentioned herein means that specific features, structures, or characteristics described with reference to the embodiment may be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiment of the present application, the term "and/or" is merely an association relationship that describes the associated object, indicating that there can be three kinds of relationships, such as A and/or B, which can be denoted as: the existence of A alone, the existence of A and B at the same time, and the existence of B alone. Moreover, the character "/" herein generally indicates that the context objects are in an "or" relationship.

In the description of the embodiment of the present application, the term "a plurality of" refers to more than two (including two), similarly, "a plurality of groups" refers to two or more groups (including two groups), and "a plurality of members" refers to more than two members (including two members).

At present, in view of market development situation, energy storage power systems are increasingly being applied. The energy storage power systems are widely used in the field of power transmission and distribution networks. As the application areas of the energy storage power systems continue to expand, the market demand for them is also continuously increasing.

With the widespread application of energy storage power systems in the power transmission and distribution networks, addressing device power supply has become a current societal issue. The energy storage systems have attracted attention due to their safe and reliable discharging. The relevant energy storage systems include a general positive line and a general negative line, as well as battery modules connected between the general positive line and the general negative line, and each battery module includes a plurality of battery packs connected in series; each battery pack includes a first metal case, a second metal case arranged inside the first metal case, and a battery cell assembly arranged inside the second metal case, in which, the first metal case and the second metal case being insulated from each other; a protection resistor is connected between the first metal case and the second metal case in each battery pack, and the first metal case in each battery pack is grounded; and therefore, short-circuit current is suppress. However, the energy storage systems can only suppress short-circuit current when insulation of a single electrical box fails and short-circuit current cannot be reduced in the case of double-point insulation fails in the cross-electrical-boxes (such as supporting members), resulting in poor safety and reliability.

In order to solve the problem that short-circuit current cannot be reduced if double-point insulation of the across-electrical-boxes (such as the supporting members) fails, the applicant has found that a conductive path can be designed, and the conductive path includes K nodes connected in series, K supporting members are connected to the K nodes through K paths, respectively, and protection assemblies are arranged on the conductive path and/or the paths; and therefore, the current between two or more supporting members can be influenced by the protection assemblies, thereby improving the safety and reliability of the energy storage system.

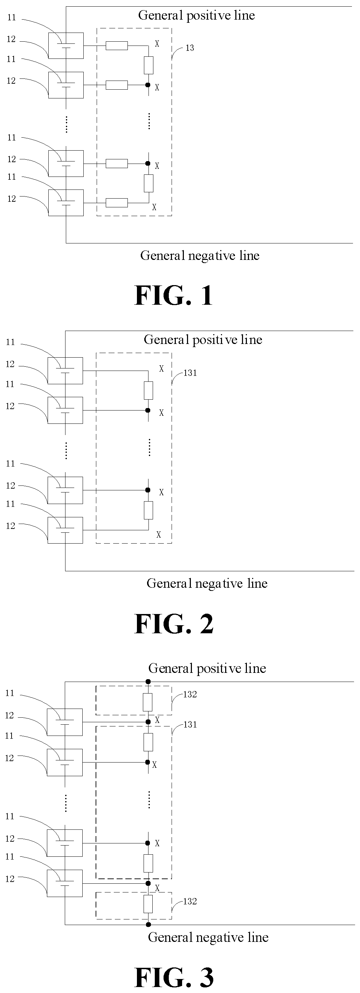

According to some embodiments of the present application, with reference to FIG. 1, FIG. 1 is a schematic structural diagram provided in one embodiment of the present application, for the sake of description, only the parts related to this embodiment are shown, and the details are as follows:
the energy storage system includes a general positive line, a general negative line, and a battery module connected between the general positive line and the general negative line; the energy storage system is configured to output electric energy from the battery module by means of the general positive line and the general negative line, and/or, the energy storage system is configured to input electric energy to the battery module by means of the general positive line and the general negative line;
the battery module includes M battery assemblies 11 connected in series.

The energy storage system further includes N supporting members, in which, the M battery modules 11 are supported by means of the N supporting members, and the M battery assemblies 11 are insulated from the N supporting members;
the energy storage system further includes a conductive path, in which, K supporting members among the N supporting members are connected to the conductive path by means of K branches, respectively, M, N, and K are all positive integers, and M≥N≥K>1; and
a protection assembly 13 is arranged on the conductive path and/or the branches in series.

A protection assembly 13 includes an electrical protection assembly for influencing the electrical performance between the N supporting members, and the electrical performance includes electric potential or current.

In one embodiment, the K supporting members among the N supporting members are respectively commonly connected through the K branches.

As one example, a first battery assembly in battery assemblies that are connected in series is supported by a first supporting assembly, and an Mth battery assembly in the battery assemblies that are connected in series is supported by an Nth supporting assembly; as another example, every two battery assemblies among the M battery assemblies are supported by one of the N supporting members, in which, the first battery assembly and a second battery assembly are supported by the first supporting member, a third battery assembly and a fourth assembly are supported by the second supporting member, and an (M-1)th battery assembly and the Mth battery assembly are supported by the Nth supporting member.

It is to be noted that the energy storage system can be an energy storage circuit in one embodiment.

It is to be understood that the general positive line and the general negative line are configured to input or output electric power. The battery assembly 11 includes one or more cells which are connected in parallel and/or in series. The supporting member 12 is configured to accommodate and/or support the battery assemblies, the supporting member can include, for example, a case and/or a cooling plate, the case or the cooling plate can be made of a metal material, and as one example, the supporting member is an electrical box, and the battery assemblies are accommodated and supported in the electrical box. It is to be noted that the cooling plate is a battery cooling plate, the battery cooling plate is, for example, a sheet located below the battery assembly 11, and it is mainly configured to transfer out heat in the battery to keep the temperature of the battery stable, thereby improving the operating efficiency of the battery. Each supporting member 12 can support one or more battery assemblies 11. The branches and conductive path can be conductive lines, or include conductive lines and other conductive components. The protection assembly 13 can include a current limiting assembly and an overcurrent protection assembly. It is to be noted that in FIG. 1, it only shows the protection assembly 13, and the protection assembly 13 is arranged between adjacent nodes and is connected in series on the respective paths.

According to the technical solution of the embodiment of the present application, the battery assemblies 11 and the supporting members 12 are arranged in an insulated manner; the K supporting members among the N supporting members are connected to the conductive path by means of the K branches, respectively, and the protection assembly is arranged on the conductive path and/or the branches, such that if double-point insulation of cross-electrical-boxes (the supporting members) fails, namely, if insulation of the supporting members 12 fails, the protection assembly 13 connected in series between two supporting members 12 with insulation failure influences current among the N supporting members 12 to achieve a protection effect, reducing short-circuit current, and reducing the possibility of initiating high-voltage ignition and battery combustion and explosion.

According to some embodiments of the present application, optionally, as shown in FIG. 2, the K branches are connected to the conductive path to form K nodes X; the protection assembly 13 includes at least one first sub-protection assembly 131, and the number of the at least one first sub-protection assembly 131 is ≤ K-1; and one or zero of the at least one first sub-protection assembly 131 is connected in series between any two adjacent nodes in the K nodes.

It is to be understood that the first sub-protection assembly 131 can be connected in series onto any two nodes X. If there are supporting members 12, one first sub-protection assembly 131 is provided; and if there are three or more supporting members 12, one or more first sub-protection assemblies 131 can be provided.

By means of above solution, the number of the first sub-protection assemblies 131 configured can be reduced, thus saving the cost.

In some embodiments, K-1 first sub-protection assemblies 131 are provided, and one first sub-protection assembly 131 is connected in series between any two adjacent nodes in the K nodes X.

It is to be understood that any two adjacent nodes among the K nodes X share K-1 sub-paths, K-1 first sub-protection assemblies 131 is are provided, and therefore, one first sub-protection assembly 131 is connected onto each sub-path.

By means of above solution, the first sub-protection assembly 131 is arranged between every two adjacent supporting members, such that if insulation of any two supporting members fails, there will be one sub-protection assembly to influence the short-circuit current, thus further reducing the possibility of initiating high-voltage ignition and battery combustion and explosion.

According to some embodiments of the present application, optionally, the conductive path includes K-1 sub-paths formed by the K nodes, a target sub-path is arranged every m sub-paths, the target sub-paths are connected in series with the first sub-protection assemblies 131, and m is a natural number.

It is to be understood that the first sub-protection assemblies 131 are uniformly distributed among a plurality of supporting members 12, and due to the protection of one or more first sub-protection assemblies 131, short-circuit current can be reduced, the uniformly-distributed first sub-protection assemblies 131 further reduce the possibility of initiating high-voltage ignition and battery combustion and explosion.

By means of above solution, the first sub-protection assemblies 131 can be arranged every 0 or more sub-paths, thereby improving the configuration flexibility of the first protection assemblies.

In some embodiments of the present application, optionally, m is 0, K-1 first sub-protection assemblies 131 are provided, and the K-1 first sub-protection assemblies 131 are connected in series onto the K-1 sub-paths, respectively.

It is to be understood that one first sub-protection assembly 131 is arranged between every two adjacent supporting members 12, such that if insulation of any two supporting members 12 fails, one or more sub-protection assemblies will influence the short-circuit current.

By means of above solution, the first sub-protection assemblies 131 are arranged between every two adjacent supporting members 12, such that if insulation of any two supporting members 12 fails, there will be one sub-protection assembly to influence the short-circuit current, thus further reducing the possibility of initiating high-voltage ignition and battery combustion and explosion.

In some embodiments, optionally, a positive electrode of a first battery assembly 11 is connected to the general positive line, and a first node formed by connecting a first branch in the K branches to the conductive path is connected to the general positive line; and a negative electrode of an Mth battery assembly 11 is connected to the general negative line, and a Kth node formed by connecting a Kth branch in the K branches to the conductive path is connected to the general negative line.

It is to be understood that a first node and the Kth node are correspondingly connected to the general positive line and the general negative line, including direct connection, and connection through the first supporting member or the Kth supporting member.

The configuration of the sub-protection assemblies between the general positive line and the first supporting member is simplified, while the configuration of the sub-protection assemblies between the general negative line and the Nth supporting member is simplified, and thus the hardware cost is saved.

By means of above solution, the protection assemblies form a voltage-sharing chain, and the voltage-sharing chain provides the possibility of serving as a voltage dividing resistor, such that it is not needed to arrange the voltage dividing resistor, the hardware design is simplified, and the cost is saved.

According to some embodiments of the present application, with reference to FIG. 3, FIG. 3 is a schematic structural diagram provided in another embodiment of the present application, for the sake of description, only the parts related to this embodiment are shown, and the details are as follows:
besides all components and assemblies of the energy storage system as shown in FIG. 1, the energy storage system further includes two second sub-protection assemblies 132.

One second sub-protection assembly 132 is connected in series between the first node and the general positive line, as well as between the Kth node and the general negative line, respectively.

The second sub-protection assemblies 132 are configured to influence the current between the first supporting member 12 and the general positive line, as well as the current between the Nth supporting member 12 and the general negative line.

It is to be noted that the second sub-protection assemblies 132 may include a second resistor assembly or a second overcurrent assembly.

The first sub-protection assembly 131 and the two second sub-protection assemblies 132 form the voltage-sharing chain to perform voltage sharing on the voltage between every two adjacent supporting members 12.

One second sub-protection assembly 132 is connected in series between the first node and the general positive line, as well as between the Kth node and the general negative line, respectively, therefore, if the insulation of the first supporting member 12 and/or an Nth supporting member 12 fails, there is one sub-protection assembly to affect the short-circuit current, thereby further reducing the possibility of initiating high-voltage ignition and battery combustion and explosion.

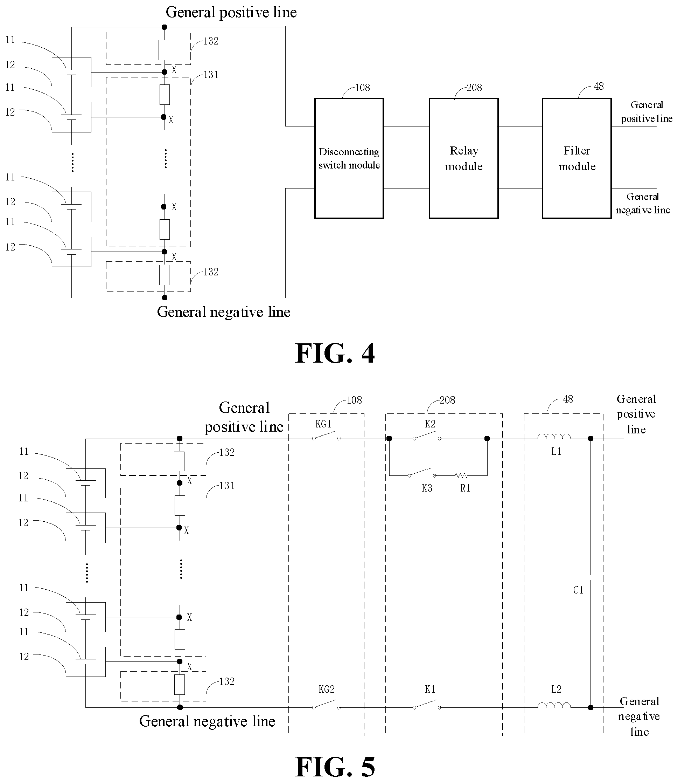

According to some embodiments of the present application, with reference to FIG. 4, FIG. 4 is a schematic structural diagram provided in another embodiment of the present application, for the sake of description, only the parts related to this embodiment are shown, and the details are as follows:
besides all components and assemblies of the energy storage system as shown in FIG. 3, a disconnecting switch module 108, a relay module 208, and a filter module 48 are sequentially connected in series on the general positive line and the general negative line; the filter module 48 is configured to filter a first direct current outputted by the battery module;
the second sub-protection assemblies 132 are only commonly connected to the disconnecting switch module 108; or
the second sub-protection assemblies 132 are commonly connected to the disconnecting switch module 108 and the relay module 208; or
the second sub-protection assemblies 132 are commonly connected to the filter module 48.

If the second sub-protection assemblies 132 are only commonly connected to the disconnecting switch module 108, the wiring is facilitated, it is not needed to set different protection modes for various operating conditions; and the voltage-sharing chain is in a non-suspended state, such that the protection mode is simple.

If the second sub-protection assemblies 132 are commonly connected to the disconnecting switch module 108 and the relay module 208, the voltage of the voltage-sharing chain can be disconnected by disconnecting the disconnecting switch module 108, and thus the safety is improved, but the voltage-sharing chain is in a suspended state.

If the second sub-protection assemblies 132 are commonly connected to the filter module 48, the voltage-sharing chain is connected to an alternating current side of the energy storage system, and the voltage-sharing chain is in a non-suspended state.

In a specific embodiment, as shown in FIG. 5, the disconnecting switch module 108 includes a first disconnecting switch KG1 and a second disconnecting switch KG2; the first disconnecting switch KG1 is connected in series onto the general positive line, and the second disconnecting switch KG2 is connected in series onto the general negative line.

The relay module 208 includes a precharge assembly that is connected in series onto the general positive line and a first relay K1 that is connected in series onto the general negative line; the precharge assembly includes a second relay K2, a third relay K3, and a first resistor R1; and the third relay K3 and the first resistor R1 are connected in series and then connected in parallel with the second relay K2.

The filter module 48 includes a first inductor L1, a second inductor L2, and a first capacitor C1; the first inductor L1 is connected in series onto the general positive line, and the second inductor L2 is connected in series onto the general negative line; and the first capacitor C1 is connected between the general positive line and the general negative line.

The disconnecting switch module, the relay module, and the filter module are sequentially connected in series onto the general positive line and the general negative line, thereby improving the stability of the first direct current, as well as improving the output flexibility of the first direct current; and the second sub-protection assembly is connected to different positions on the general positive line and the general negative line, thereby improving the protection flexibility of the energy storage system.

In some embodiments, each first sub-protection assembly has the same resistance.

It is to be understood that each first sub-protection assembly has the same resistance, so that the voltage drop of each first sub-protection assembly is the same.

The resistance of each second sub-protection assembly can be smaller than or equal to the resistance of the corresponding first sub-protection assembly; or
the resistance of each second sub-protection assembly is a preset multiple of the resistance of the corresponding first sub-protection assembly, and the preset multiple can be 1.5, 2, 2.5, and 3.

By means of above solution, the voltage differences between the adjacent supporting members 12 are equal, therefore, if insulation of the two supporting members 12, the stability of the current limiting effect of one or more first sub-protection assemblies is improved, thereby further reducing the possibility of initiating high-voltage ignition and battery combustion and explosion.

In some embodiments, if the resistance of each first sub-protection assembly is a first resistance R, and m is greater than 0, the resistance of each first sub-protection assembly is a first configuration resistance mR.

It is to be understood that the resistance of each second sub-protection assembly 132 can be half of the first resistance. The voltage difference between every two adjacent supporting members 12 is Vbus/n; the voltage difference between the first supporting member 12 and the general positive line is Vbus/2n; the voltage difference between the nth supporting member 12 and the general negative line is Vbus/2n; and Vbus/ is the voltage difference between the general negative line and the general positive line. The first sub-protection assembly and the second sub-protection assembly achieve voltage difference balance between the adjacent supporting members 12. Therefore, the voltage differences between the adjacent supporting members 12 are equal, and the voltage difference between the first supporting member 12 and the general positive line as well as the voltage difference between the nth supporting member 12 and the general negative line are half of the voltage differences between the adjacent supporting members 12, thereby further improving the stability of the current limiting effect of the voltage-sharing chain, and further reducing the possibility of initiating high-voltage ignition and battery combustion and explosion.

It is to be understood that the resistance of each second sub-protection assembly can be twice of the first preset resistance. The purpose of distinguishing voltages is achieved, and insulation detection is facilitated.

If m is greater than 0, the voltage drop of each first sub-protection assembly is m*Vbus/n, the voltage difference between the first supporting member 12 and the general positive line is Vbus/2n; and the voltage difference between the nth supporting member 12 and the general negative line is Vbus/2n.

By means of above solution, the voltage drop of each first sub-protection assembly is the same, and the voltage difference between the first supporting member 12 and the general positive line and the voltage difference between the nth supporting member 12 and the general negative line are half of the voltage drop m of each first sub-protection assembly 131, thus the stability of the current limiting effect of the voltage-sharing chain is further improved, and the possibility of initiating high-voltage ignition and battery combustion and explosion is further reduced.

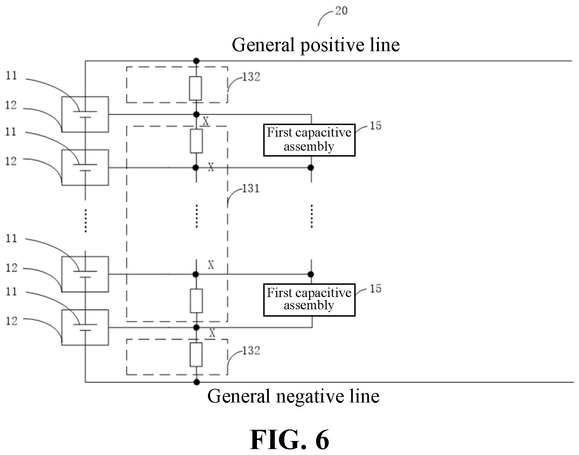

According to some embodiments of the present application, with reference to FIG. 6, FIG. 6 is a schematic structural diagram provided in another embodiment of the present application, for the sake of description, only the parts related to this embodiment are shown, and the details are as follows:
besides all components and assemblies of the energy storage system as shown in FIG. 3, the energy storage system further includes a plurality of first capacitive assemblies 15.

The plurality of first capacitive assemblies 15 are connected in parallel with the plurality of first sub-protection assemblies one by one.

In cases of lightning strikes, surges, and the like, peak current occurs on each first sub-protection assembly, and each first capacitive assembly 151 will perform peak voltage suppression on the voltage of each first sub-protection assembly.

By means of above solution, in cases of lightning strikes, surges, and the like, each first capacitive assembly will perform peak voltage suppression on the voltage each first sub-protection assembly, thereby reducing the probability of breakdown of the first sub-protection assemblies, improving the reliability of the energy storage system, and moreover, filtering out the spike voltage between the general positive line and general negative line, enhancing the stability of the energy storage system.

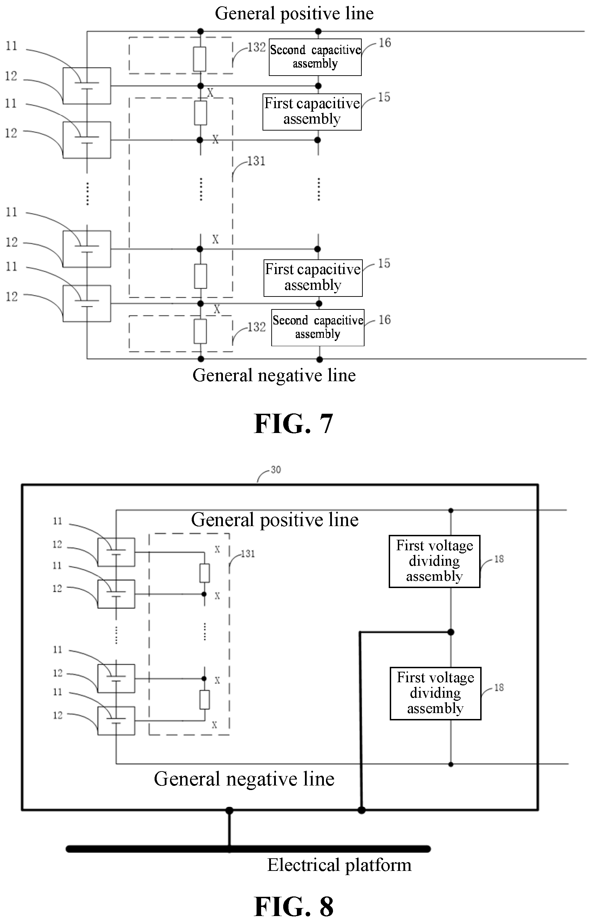

According to some embodiments of the present application, with reference to FIG. 7, FIG. 7 is a schematic structural diagram provided in another embodiment of the present application, for the sake of description, only the parts related to this embodiment are shown, and the details are as follows:
besides all components and assemblies of the energy storage system as shown in FIG. 6, the energy storage system further includes a plurality of second capacitive assemblies 16.

The plurality of first capacitive assemblies 15 are connected in parallel with the plurality of first sub-protection assemblies 131 one by one; and the plurality of second capacitive assemblies 16 are connected in parallel with the plurality of second sub-protection assemblies 132 one by one.

In cases of lightning strikes, surges, and the like, peak current occurs on each second sub-protection assembly 132, and each second capacitive assembly 16 will perform peak voltage suppression on the voltage of each second sub-protection assembly 132.

By means of above solution, in cases of lightning strikes, surges, and the like, each second capacitive assembly 16 will perform peak voltage suppression on the voltage of each second sub-protection assembly 132, thereby reducing the probability of breakdown of the second sub-protection assemblies 132, improving the reliability of the energy storage system, and moreover, filtering out the spike voltage between the general positive line and general negative line, enhancing the stability of the energy storage system.

In some embodiments, each first capacitive assembly has the same capacitance.

A quotient of the capacitance of the first capacitive assembly and the resistance of the corresponding first sub-protection assembly is the same, so that the peak voltage suppression capability on the voltage between the supporting members 12 is the same.

By means of above solution, each first capacitive assembly has the same capacitance, so that the peak voltage suppression capabilities at both ends of each first sub-protection assembly are the same, and the stability and reliability of the energy storage system are further improved.

In some embodiments, if the capacitance of each first capacitive assembly connected in parallel with each first sub-protection assembly is a first capacitance C, the capacitance of each second capacitive assembly is 1/2 of the first capacitance C.

In one embodiment, if m is 0, the capacitance of each first capacitive assembly 15 is the first capacitance; and the capacitance of each second capacitive assembly 16 is half of the first capacitance.

In one embodiment, if m is greater than 0, the capacitance of each first capacitive assembly 15 is m times of the first capacitance.

The quotient of the capacitance of each capacitive assembly and the resistance of the corresponding sub-protection assembly is the same, so that the peak voltage suppression capability on the voltage between the supporting members 12 is the same.

By means of above solution, each first capacitive assembly 15 has the same capacitance, so that the peak voltage suppression capabilities on the voltage between the supporting members 12 are the same, and the stability and reliability of the energy storage system are further improved.

According to some embodiments of the present application, with reference to FIG. 8, FIG. 8 is a schematic structural diagram provided in another embodiment of the present application, for the sake of description, only the parts related to this embodiment are shown, and the details are as follows:
besides all components and assemblies of the energy storage system as shown in FIG. 2, the energy storage system further includes a second supporting device 30 and two first voltage dividing assemblies 18;
the two first voltage dividing assemblies 18 are connected in series between the general positive line and the general negative line; and
the two first voltage dividing assemblies 18 and the second supporting device 30 are commonly connected to an electrical platform.

It is to be understood that t the two first voltage dividing assemblies 18 have the same resistance, the two first voltage dividing assemblies 18 and the second supporting device 30 are commonly connected to the electrical platform, the voltage between the electrical platform and the general positive line is the first voltage, the voltage between the electrical platform and the general negative line is the second voltage, and the first voltage is equal to the second voltage, therefore, after the electrical platform is grounded, the absolute value of the potential of the general positive line and the absolute value of the potential of the general negative line are minimum.

By means of above solution, the two second voltage dividing assemblies 18 and the second supporting device 30 are arranged, and a common contact of the two second voltage dividing assemblies 18 and the second supporting device 30 are clamped at a potential of the electrical platform, such that the safety of the energy storage system is improved, the maximum value of the absolute value of the voltage of the general positive line and the maximum value of the absolute value of the voltage of the general negative line are minimum, thereby further improving the safety and reliability of the energy storage system.

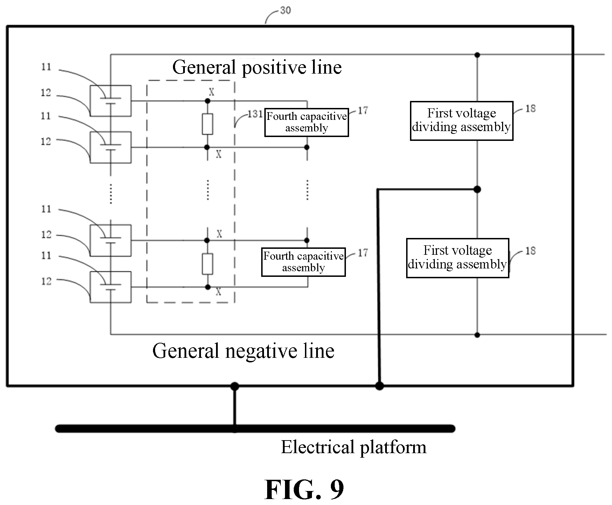

According to some embodiments of the present application, with reference to FIG. 9, FIG. 9 is a schematic structural diagram provided in another embodiment of the present application, for the sake of description, only the parts related to this embodiment are shown, and the details are as follows:
besides all components and assemblies of the energy storage system as shown in FIG. 8, the energy storage system further includes a plurality of fourth capacitive assemblies 17.

Each first sub-protection assembly is connected in parallel with each fourth capacitive assembly 17.

In a specific embodiment, each first sub-protection assembly has the same resistance, and each fourth capacitive assembly 17 has the same capacitance, so that the voltage drop of each first sub-protection assembly is the same, and the peak voltage suppression capability on each first sub-protection assembly is the same.

By means of above solution, By means of above solution, in cases of lightning strikes, surges, and the like, each fourth capacitive assembly 17 perform spike voltage suppression on the voltage of each first sub-protection assembly, thereby reducing the probability of breakdown of the first sub-protection assemblies, improving the reliability of the energy storage system.

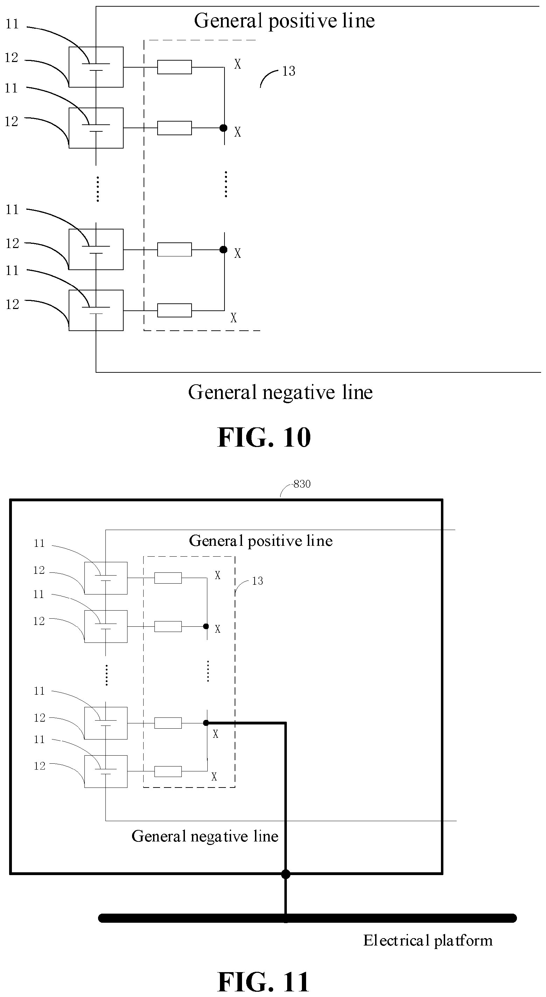

In some embodiments of the present application, optionally, as shown in FIG. 10, the protection assembly includes at least one third sub-protection assembly, the number of the third sub-protection assemblies is ≤ K, and the at least one third sub-protection assembly is connected in series to at least one of the K branches.

It is to be understood that any number of third sub-protection assemblies can be provided and can be connected in series onto any branch. FIG. 10 only shows a situation that the third sub-protection assemblies are connected in series onto each branch. It is to be noted that each node X on the conductive path is equipotential only after the third sub-protection assemblies are connected in series onto the K branches.

By means of above solution, the third sub-protection assemblies are arranged on the K branches, thus if double-point insulation of the cross-electrical-box (supporting member) fails, short-circuit current will be influenced, thereby reducing the possibility of initiating high-voltage ignition and battery combustion and explosion, while making wiring more flexible; and meanwhile, the number of the third sub-protection assemblies configured can be decreased, thus saving the cost.

In some embodiments, the protection assembly includes K third sub-protection assemblies, and the K third sub-protection assemblies are connected in series onto the K branches, respectively.

It is to be understood that the third sub-protection assemblies are arranged between every two adjacent supporting members 12, so that if the insulation of any two supporting members 12 fails, there are two third sub-protection assemblies to perform overcurrent protection on the short-circuit current.

By means of above solution, the third sub-protection assemblies are arranged between the adjacent supporting members 12, and if the insulation of any two supporting members 12 fails, at least two third protection assemblies can be used for protecting against the short-circuit current, thereby further reducing the possibility of initiating high-voltage ignition and battery combustion and explosion.

In some embodiments, each third sub-protection assembly has the same resistance.

It is to be understood that each third sub-protection assembly has the same resistance, so that the voltage drop of each third sub-protection assembly is the same.

By means of above solution, the voltage differences between the adjacent supporting members are equal, thus if the insulation of the two supporting members fails, the stability of the current limiting effect can be improved, thereby further reducing the possibility of initiating high-voltage ignition and battery combustion and explosion.

In some embodiments, the energy storage system further includes a plurality of third capacitive assemblies.

The plurality of third capacitive assemblies are connected in parallel with the at least one third sub-protection assembly one by one.

In cases of lightning strikes, surges, and the like, peak current occurs on each third sub-protection assembly, and each third capacitive assembly will perform peak voltage suppression on the voltage of each third sub-protection assembly.

By means of above solution, in cases of lightning strikes, surges, and the like, each third capacitive assembly performs spike voltage suppression on voltage of each third sub-protection assembly, thereby reducing the probability of breakdown of the third sub-protection assemblies, improving the reliability of the energy storage system, and moreover, filtering out the spike voltage between the general positive line and general negative line, enhancing the stability of the energy storage system.

In some embodiments, one or more of the N supporting members are connected to the electrical platform.

As understood by those skilled in the art, the electrical platform can be given a potential, and/or, the electrical platform can be provided with a potential. As an example, the electrical platform can be an equipotential object, so that apparatuses that are connected to the electrical platform have the same potential; and in some embodiments, the electrical platform includes a valve tower platform of an energy storage valve, which can be connected to the power ground.

Any node of the voltage-sharing chain can be connected to the electrical platform; the voltage of the general negative line and the general positive line changes with the nodes connected to the electrical platform, thereby adapting to various application scenarios and enriching the product functionality.

By means of above solution, the voltage-sharing chain including the protection assemblies is used as the voltage dividing resistor at the same time, such that it is not needed to arrange the voltage dividing resistor, the hardware design is simplified, and the cost is saved.

In some embodiments, if N is an even number, the N/2th supporting member is connected to the electrical platform; and
if N is an odd number, the (N +1)/2th supporting member is connected to the electrical platform.

It is to be understood that if N is the odd number, the voltage between the electrical platform and the general positive line is the first voltage, the voltage between the electrical platform and the general negative line is the second voltage, the first voltage is equal to the second voltage, therefore, if the electrical platform is grounded, the absolute value of the voltage of the general positive line and the absolute value of the voltage of the general negative line are minimum. If N is the even number, the voltage between the electrical platform and the general positive line is the first voltage, the voltage between the electrical platform and the general negative line is the second voltage, and the first voltage and the second voltage are closest to each other. If the electrical platform is grounded, the absolute value of the voltage of the general positive line and the absolute value of the voltage of the general negative line are minimum in the same way.

By means of above solution, the middlemost supporting member is connected to the electrical platform, thus if the electrical platform is grounded, the maximum value of an absolute value of the voltage of the general positive line and the absolute value of the voltage of the general negative line is minimum, thereby further improving the safety and the reliability of the energy storage system.

In some embodiments, the energy storage system further includes a first supporting device, and the first supporting device is configured to support the N supporting members and is connected to the electrical platform.

The supporting device is configured to support and/or accommodate the electrical box, the battery, and the like, and the supporting device includes an electrical cabinet.

By means of above solution, the first supporting device is connected to the electrical platform, thus the wiring is facilitated, it is not needed to set different protection modes for various operating conditions; and the first supporting device is in a non-suspended state, such that the protection mode is simple.

In some embodiments, one of the general positive line, the general negative line, and the conductive path is connected to the electrical platform.

As an example, if the electrical platform is grounded, the devices (such as an electrical box case of the battery) connected to the electrical platform are generally considered to be grounded; in this example, the electrical platform given a grounding potential by grounding, and the devices connected to the electrical platform are considered to provide the grounding potential through the electrical platform; and as another example, if the electrical platform is connected to the general positive line of the electrical cabinet, the electrical platform can be considered to be given a potential of the general positive line; and if a device (such as an electrical cabinet body of the battery) is connected to the electrical platform, the device can be considered to be provided with the potential of the general positive line by the electrical platform.

By means of above solution, the wiring flexibility is improved, and various protection modes can be provided for various operating conditions.

According to some embodiments of the present application, with reference to FIG. 11, FIG. 11 is a schematic structural diagram provided in another embodiment of the present application, for the sake of description, only the parts related to this embodiment are shown, and the details are as follows:
besides all components and assemblies of the energy storage system as shown in FIG. 10, the energy storage system further includes a third supporting device 830.

The conductive path and the third supporting device 830 are commonly connected to the electrical platform.

It is to be understood that the conductive path and the third supporting device 830 are connected to the electrical platform, so that each support part is equipotential, and the protection mode is simple.

By means of above solution, the conductive path and the third supporting device 830 are commonly connected to the electrical platform, thus the wiring is facilitated, it is not needed to set different protection modes for various operating conditions; and the third supporting device 830 and each supporting member 12 are in a non-suspended state, such that the protection mode is simple.

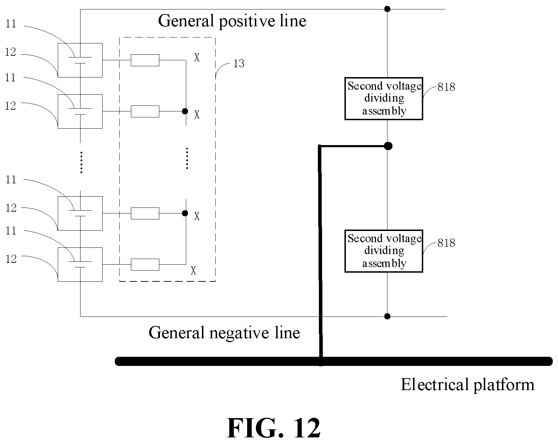

According to some embodiments of the present application, with reference to FIG. 12, FIG. 12 is a schematic structural diagram provided in another embodiment of the present application, for the sake of description, only the parts related to this embodiment are shown, and the details are as follows:
besides all components and assemblies of the energy storage system as shown in FIG. 10, the energy storage system further includes two second voltage dividing assemblies 818;
the two second voltage dividing assemblies 818 are connected in series between the general positive line and the general negative line; and
an intermediate node of the two second voltage dividing assemblies 818 is connected to the electrical platform.

It is to be understood that the two second voltage dividing assemblies 818 have the same resistance; the two second voltage dividing assemblies 818 are commonly connected to the electrical platform, the voltage between the electrical platform and the general positive line is the first voltage, the voltage between the electrical platform and a general negative line is the second voltage, the first voltage and the second voltage are equal, therefore, if the electrical platform is grounded, the absolute value of the potential of the general positive line and the absolute value of the potential of the general negative line are the minimum.

By means of above solution, the two second voltage dividing assemblies 818 are arranged, and the common nodes of the two second voltage dividing assemblies 818 are clamped at the potential of the electrical platform, such that the safety of the energy storage system is improved, the maximum value of the absolute value of the voltage of the general positive line and the maximum value of the absolute value of the voltage of the general negative line are minimum, thereby further improving the safety and reliability of the energy storage system.

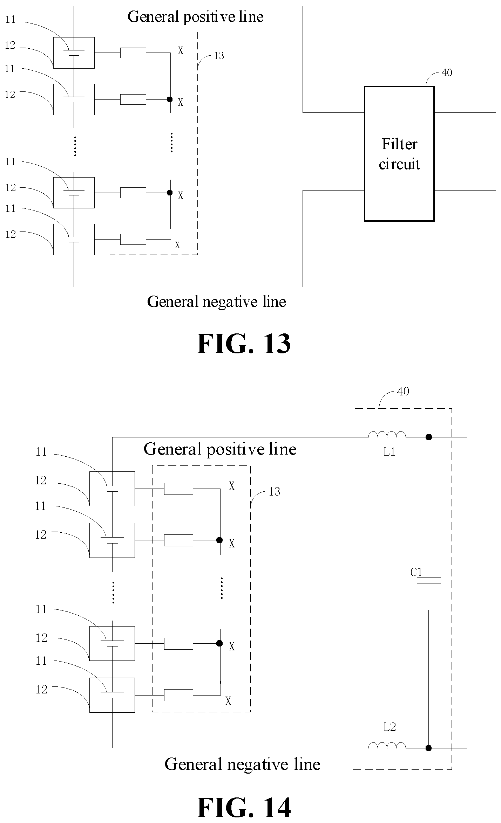

According to some embodiments of the present application, with reference to FIG. 13, FIG. 13 is a schematic structural diagram provided in another embodiment of the present application, for the sake of description, only the parts related to this embodiment are shown, and the details are as follows:
besides all components and assemblies of the energy storage system as shown in FIG. 10, filter circuits 40 are connected in series onto the general positive line and the general negative line; and the filter circuits 40 are configured to filter the first direct current outputted by the battery module.

In a specific embodiment, as shown in FIG. 14, the filter circuits 40 include first inductors L1, second inductors L2, and first capacitors C1; the first inductors L1 are connected in series onto the generative positive line; the second inductors L2 are connected in series onto the general negative line; and the first capacitors C1 are connected between the general positive line and the general negative line.

The filter circuits are connected onto the general positive line and the general negative line in series, thereby improving the stability of first direct current.

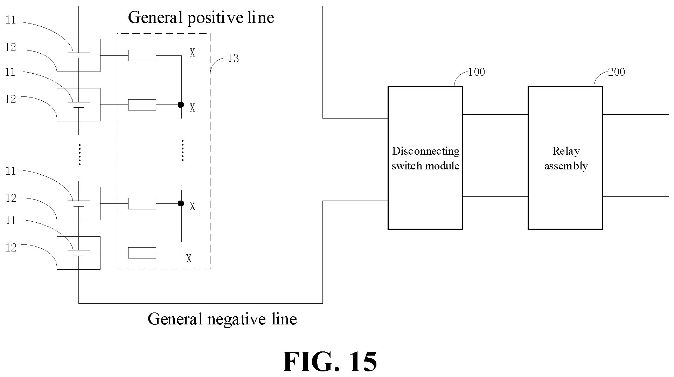

According to some embodiments of the present application, with reference to FIG. 15, FIG. 15 is a schematic structural diagram provided in another embodiment of the present application, for the sake of description, only the parts related to this embodiment are shown, and the details are as follows:
besides all components and assemblies of the energy storage system as shown in FIG. 10, a disconnecting switch assembly 100 and a relay assembly 200 are sequentially connected in series onto the general positive line and the general negative line.

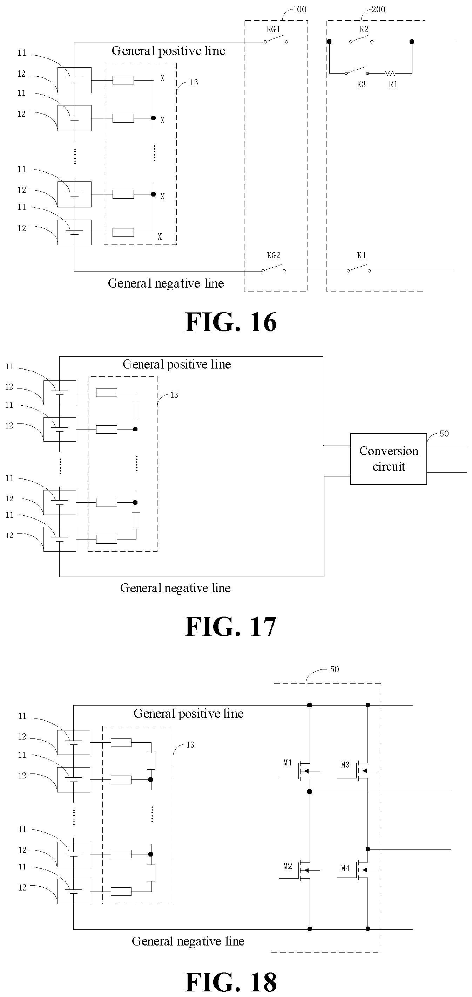

In a specific implementation, as shown in FIG. 16, the disconnecting switch assembly 100 includes a first disconnecting switch KG1 and a second disconnecting switch KG2; the first disconnecting switch KG1 is connected in series onto the general positive line in series, and the second disconnecting switch KG2 is connected in series onto the general negative line.

The relay assembly 200 includes a precharge assembly that is connected in series onto the general positive line and a first relay K1 that is connected in series onto the general negative line in series; the precharge assembly includes a second relay K2, a third relay K3, and a first resistor R1; and the third relay K3 and the first resistor R1 are connected in series and then are connected in parallel with the second relay K2.

The disconnecting switch assembly and the relay assembly are sequentially connected in series onto the general positive line and the general negative line, thereby improving the flexibility of first direct current output.

According to some embodiments of the present application, with reference to FIG. 17, FIG. 17 is a schematic structural diagram provided in another embodiment of the present application, for the sake of description, only the parts related to this embodiment are shown, and the details are as follows:
besides all components and assemblies of the energy storage system as shown in FIG. 1, the energy storage system further includes a conversion circuit 50.

The conversion circuit 50 is connected to the general positive line and the general negative line and is configured to convert a first direct current outputted by the battery module so as to output the alternating current.

As an example but not limitation, as shown in FIG. 18, the conversion circuit 50 includes a first IGBT M1, a second IGBT M2, a third IGBT M3, and a fourth IGBT M4; a drain electrode of the first IGBT M1, a drain electrode of the third IGBT M3, a source electrode of the second IGBT M2, and a source electrode of the fourth IGBT M4 are jointly used as a first direct current input end of the conversion circuit 50 and are connected to the general positive line and the general negative line to access the first direct current; and a source electrode of the first IGBT M1, a source electrode of the third IGBT M3, a drain electrode of the second IGBT M2, and a drain electrode of the fourth IGBT M4 are jointly used as an alternating current output end of the conversion circuit 50 to output the alternating current.

By means of above solution, the first direct current is subjected to direct-current and alternating-current conversion to realize alternating-current output of the energy storage module.

In some embodiments of the present application, optionally, the protection assembly 13 is a current limiting assembly which is configured to limit the current generated in the conductive path; or
the protection assembly 13 is an overcurrent protection assembly which is configured to carry out overcurrent protection on the conductive path.

It is to be noted that the current limiting assembly can include a resistor assembly; and in a specific embodiment, the resistance of the current limiting assembly 131 can be between kΩ level and MΩ level. The current limiting assembly reduces the short-circuit current, reduces the possibility of initiating high-voltage ignition and battery combustion and explosion, and can maintain the normal operation of the energy storage system.

The overcurrent protection assembly can include a fuse, a fuse link, an electronic circuit breaker, a current protection switch, and an overcurrent relay. The overcurrent protection assembly disconnects two supporting members 12 with insulation failure, thus reducing the possibility of initiating high-voltage ignition and battery combustion and explosion, and further improving the safety and reliability.

By means of above solution, the protection assembly 13 can be the current limiting assembly or the overcurrent protection assembly, and thus the configuration flexibility of the protection assembly is improved.

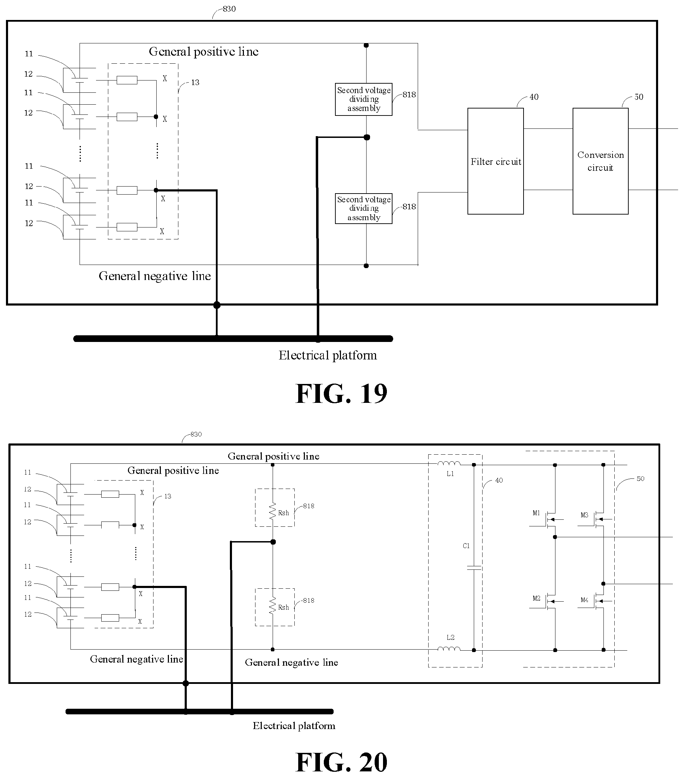

According to some embodiments of the present application, with reference to FIG. 19, FIG. 19 is a schematic structural diagram provided in another embodiment of the present application, for the sake of description, only the parts related to this embodiment are shown, and the details are as follows:
besides all components and assemblies of the energy storage system as shown in FIG. 11, the energy storage system further includes the filter circuits 40, the conversion circuit 50, and the two second voltage dividing assemblies 818.
the two second voltage dividing assemblies 818 are connected in series between the general positive line and the general negative line; and

The two second voltage dividing assemblies 818 are commonly connected to the electrical platform.

The filter circuits 40 are connected to the general positive line and the general negative line, and are configured to filter the first direct current outputted by the battery module.

The conversion circuit 50 is connected to the filter circuits 40, and is configured to convert the filtered first direct current so as to output the alternating current.

In a specific embodiment, as shown in FIG. 20, the filter circuits 40 include first inductors L1, second inductors L2, and first capacitors C1; the first inductors L1 are connected in series onto the generative positive line; the second inductors L2 are connected in series onto the general negative line; and the first capacitors C1 are connected between the general positive line and the general negative line.

The conversion circuit 50 includes the first IGBT M1, the second IGBT M2, the third IGBT M3, and the fourth IGBT M4; the drain electrode of the first IGBT M1, the drain electrode of the third IGBT M3, the source electrode of the second IGBT M2, and the source electrode of the fourth IGBT M4 are jointly used as the first direct current input end of the conversion circuit 50, and are connected to the general positive line and the general negative line to access the first direct current; and the source electrode of the first IGBT M1, the source electrode of the third IGBT M3, the drain electrode of the second IGBT M2, and the drain electrode of the fourth IGBT M4 are jointly used as the alternating current output end of the conversion circuit 50 to output the alternating current.

The second voltage dividing assemblies 818 includes a voltage dividing resistor Rsh.

The filter circuits and the conversion circuit are connected in series onto the general positive line and the general negative line, such that the stability and the output flexibility of first direct current are improved; the common contact of the two second voltage dividing assemblies 818 is clamped at the potential of the electrical platform, thus the safety of the energy storage system is improved, and moreover, the maximum value of the absolute value of the voltage of the general positive line and the absolute value of the voltage of the general negative line is minimum, thereby further improving the safety and the reliability of the energy storage system; and the first direct current is subjected to direct current and alternating current converting, thus achieving alternating current output of an energy storage module.

According to some embodiments of the present application, the present application also provides a power source apparatus, which includes the energy storage system in any solutions above.

In a specific embodiment, the power source apparatus can include an energy storage station; the energy storage system stores electric energy for the energy storage station and releases the electric energy when a power grid is lack of energy.

The power source apparatus includes the energy storage system in any solution above, so the short circuit current can be influenced, and the possibility of initiating high-voltage ignition and battery combustion and explosion can be reduced.

Finally, it is to be noted that the above embodiments are only used for illustrating the technical solutions of the present application, not to limit them, and although the present application is described in detail with reference to the foregoing embodiments, those of ordinary skill in the art should understand that it may still modify the technical solutions described in the foregoing embodiments, or replace some or all of the technical features therein, and these modifications or substitutions do not make the essence of the corresponding technical solutions out of the scope of the technical solutions of the embodiments of the present application, and they should be covered by the scope of the claims and description of the present application. In particular, the technical features mentioned in the various embodiments can be combined in any manner as long as there is no structural conflict. The present application is not limited to the particular embodiments disclosed herein, but rather includes all technical solutions falling within the scope of the claims.

## Claims

1. An energy storage system, comprising a general positive line, a general negative line, and a battery module connected between the general positive line and the general negative line, wherein the energy storage system is configured to output electric energy from the battery module by means of the general positive line and the general negative line, and/or, the energy storage system is configured to input electric energy to the battery module by means of the general positive line and the general negative line;
the battery module comprises M battery assemblies connected in series;
the energy storage system further comprises N supporting members, in which, the M battery modules are supported by means of the N supporting members, and the M battery assemblies are insulated from the N supporting members;
the energy storage system further comprises a conductive path, in which, K supporting members among the N supporting members are connected to the conductive path by means of K branches, respectively, M, N, and K are all positive integers, and M≥N≥K>1; and
a protection assembly is arranged on the conductive path and/or the branches.

2. The energy storage system according to claim 1, wherein the K branches are connected to the conductive path to form K nodes;
the protection assembly comprises at least one first sub-protection assembly, and the number of the at least one first sub-protection assembly is ≤ K-1; and one or zero of the at least one first sub-protection assembly is connected in series between any two adjacent nodes in the K nodes.

3. The energy storage system according to claim 2, wherein the number of the at least one first sub-protection assembly is K-1, and one of the at least one first sub-protection assembly is connected in series between any two adjacent nodes in the K nodes.

4. The energy storage system according to claim 2, wherein the conductive path comprises K-1 sub-paths formed by the K nodes, a target sub-path is arranged every m sub-paths, the target sub-paths are connected in series with the first sub-protection assemblies, and m is a natural number.

5. The energy storage system according to claim 4, wherein m is 0, the number of the at least one first sub-protection assembly is K-1, and the K-1 first sub-protection assemblies are connected in series with the K-1 sub-paths, respectively.

6. The energy storage system according to any one of claims 2 to 5, wherein each first sub-protection assembly has the same resistance.

7. The energy storage system according to any one of claims 2 to 6, further comprising:
a plurality of first capacitive assemblies connected in parallel with the plurality of first sub-protection assemblies one by one.

8. The energy storage system according to claim 7, wherein each first capacitive assembly has the same capacitance.

9. The energy storage system according to any one of claims 1 to 8, wherein a positive electrode of a first battery assembly is connected to the general positive line, and a first node formed by connecting a first branch in the K branches to the conductive path is connected to the general positive line; and a negative electrode of an Mth battery assembly is connected to the general negative line, and a Kth node formed by connecting a Kth branch in the K branches to the conductive path is connected to the general negative line.

10. The energy storage system according to claim 9, further comprising two second sub-protection assemblies, wherein one second sub-protection assembly is connected in series between the first node and the general positive line, as well as between the Kth node and the general negative line, respectively.

11. The energy storage system according to claim 10, wherein a disconnecting switch module, a relay module, and a filter module are sequentially connected in series onto the general positive line and the general negative line; the filter module is configured to filter a first direct current outputted by the battery module;
the second sub-protection assemblies are commonly connected to the disconnecting switch module; or
the second sub-protection assemblies are commonly connected to the disconnecting switch module and the relay module; or
the second sub-protection assemblies are commonly connected to the filter module.

12. The energy storage system according to claim 10 or 11, wherein if the resistance of each first sub-protection assembly is a first resistance R, the resistance of each second sub-protection assembly is half or twice of the first resistance R.

13. The energy storage system according to any one of claims 10 to 12, further comprising:
a plurality of second capacitive assemblies which are connected in parallel with the plurality of second sub-protection assemblies one by one.

14. The energy storage system according to claim 13, wherein if the capacitance of each first capacitive assembly connected in parallel with each first sub-protection assembly is a first capacitance C, the capacitance of each second capacitive assembly is 1/2 of the first capacitance C.

15. The energy storage system according to any one of claims 1 to 14, wherein the protection assembly comprises at least one third sub-protection assembly, the number of the third sub-protection assemblies is ≤ K, and the at least one third sub-protection assembly is connected in series onto at least one of the K branches.

16. The energy storage system according to claim 15, wherein the protection assembly comprises K third sub-protection assemblies, and the K third sub-protection assemblies are connected in series onto the K branches, respectively.

17. The energy storage system according to claim 15 or 16, wherein each third sub-protection assembly has the same resistance.

18. The energy storage system according to any one of claims 15 to 17, further comprising:
a plurality of third capacitive assemblies which are connected in parallel with the at least one third sub-protection assembly one by one.

19. The energy storage system according to any one of claims 1 to 18, wherein one or more of the N supporting members are connected to an electrical platform.

20. The energy storage system according to claim 19, wherein if N is an even number, the N/2th supporting member is connected to the electrical platform; and
if N is an odd number, the (N +1)/2th supporting member is connected to the electrical platform.

21. The energy storage system according to claim 19 or 20, further comprising a first supporting device, wherein the first supporting device is configured to support the N supporting members and is connected to the electrical platform.

22. The energy storage system according to any one of claims 19 to 21, wherein one of the general positive line, the general negative line, and the conductive path is connected to the electrical platform.

23. The energy storage system according to any one of claims 19 to 21, further comprising two second voltage dividing assemblies, wherein
the two second voltage dividing assemblies are connected in series between the general positive line and the general negative line; and
an intermediate node of the two second voltage dividing assemblies is connected to the electrical platform.

24. The energy storage system according to any one of claims 1 to 23, further comprising:
a conversion circuit which is connected to the general positive line and the general negative line and is configured to convert a first direct current outputted by the battery module so as to output an alternating current.

25. The energy storage system according to any one of claims 1 to 24, wherein the protection assembly is a current limiting assembly which is configured to limit the current generated in the conductive path; or
the protection assembly is an overcurrent protection assembly which is configured to carry out overcurrent protection on the conductive path.

26. A power source apparatus, comprising the abovementioned energy storage system according to any one of claims 1 to 25.
